# EUROPEAN PATENT APPLICATION

(11) **EP 4 757 079 A1**
(43) Date of publication of application: **10.06.2026**
(21) Application number: 25213686.6
(22) Date of filing: 05.11.2025
(51) Int. Cl.: H01R 12/70, H01R 12/72, H01R 12/71, H01R 24/60

(54) **CONNECTOR, CONNECTOR UNIT, AND METHOD FOR CONNECTING TO CONNECTION SUBSTRATE IN CONNECTOR**

(30) Priority: 06.12.2024 JP 2024213026
(71) Applicant: Japan Aviation Electronics Industry, Ltd., Tokyo 150-0043 (JP)
(72) Inventor: TANAKA, Yukitaka, Tokyo (JP); TODA, Kentaro, Tokyo (JP)
(74) Representative: INNOV-GROUP

(57) **Abstract**

A connector that contributes to improving signal transmission characteristics is provided. A connector (2) according to the present disclosure includes a contact assembly (12) including an insulating member (23) that holds a first contact group (21) and a second contact group (22). The insulating member (23) includes a main body (23a) holding the first contact group (21) and the second contact group (22), protruding parts (23b) protruded from the main body (23a), engaged parts (23f) with which engaging parts (3d) of the connection substrate (3) are engaged, and contacting parts that are in contact with side surfaces of the connection substrate (3). The engaged parts (23f) sandwich side parts of the connection substrate (3). End parts of each of the first contact group (21) and the second contact group (22) connected to the connection substrate (3) are disposed between the protruding parts (23b) in a state in which the end parts are protruded from the insulating member (23).

## Description

### BACKGROUND

The present disclosure relates to a connector, a connector unit, and a method for connecting to a connection substrate in the connector.

For example, as shown in Fig. 26, a connector 101 disclosed in Patent Literature 1 is configured to be able to connect connection terminal parts of a substrate 103 to contacts of the connector 101 in a state in which step parts 103a disposed on side parts of the substrate 103 are inserted into grooves 102b formed in locking parts 102a of a housing 102 and engaged therewith.

At this time, the connector 101 is configured to be able to guide the substrate 103 to the inside of the housing 102 by a guide part 102c formed in the housing 102. Then, contacts are disposed inside grooves 102d formed in a guide part 102c, and the respective contacts are surrounded by the grooves 102d.

[Patent Literature 1] Japanese Unexamined Patent Application Publication No. 2017-27699

### SUMMARY

Since the respective contacts are surrounded by the grooves 102d in the connector 101 disclosed in Patent Literature 1, this connector 101 causes problems that impedance is decreased and signal transmission characteristics are degraded.

An object of the present disclosure is to provide a connector, a connector unit, and a method for connecting to a connection substrate in the connector that contribute to improving signal transmission characteristics.

A connector according to one aspect of the present disclosure is a connector that connects a connection substrate to a connection connector, the connector including: a contact assembly including a first contact group and a second contact group that can be connected to the connection substrate in a state in which the first contact group and the second contact group sandwich the connection substrate and an insulating member that holds the first contact group and the second contact group, in which the insulating member includes: a main body configured to hold the first contact group and the second contact group; protruding parts that are protruded from the main body in a direction in which the connection connector is inserted into the connector and are disposed in such a way that they are spaced apart from each other in a width direction of the connector; engaged parts that are disposed in the protruding parts and with which engaging parts disposed in side parts of the connection substrate are engaged; and contacting parts that are disposed in the protruding parts and are in contact with side surfaces of the connection substrate, surfaces of the engaged parts that are opposed to each other in a thickness direction of the connector sandwich the side parts of the connection substrate, and end parts of each of the first contact group and the second contact group connected to the connection substrate are disposed between the protruding parts in a state in which the end parts are protruded from the insulating member in a direction in which the connection connector is inserted into the connector as seen from the thickness direction of the connector.

A connector unit according to one aspect of the present disclosure includes: the aforementioned connector; and a connection substrate connected to the connector, in which the connection substrate includes engaging parts that are disposed in side parts of the connection substrate and are engaged with engaged parts of the connector.

A method for connecting to a connection substrate in a connector according to one aspect of the present disclosure is a method for connecting to a connection substrate in a connector that connects a connection substrate to a connection connector, the method including: a process of sandwiching side parts of the connection substrate by engaged parts in a thickness direction of the connector while engaging engaging parts disposed in the side parts of the connection substrate with protruding parts that are protruded from a main body of an insulating member for holding a first contact group and a second contact group in a direction in which the connection connector is inserted into the connector and are disposed in such a way that they are spaced apart from each other in a width direction of the connector; a process of causing side surfaces of the connection substrate to be in contact with the contacting parts disposed in the protruding parts of the insulating member of the connector to sandwich the connection substrate by the contacting parts in the width direction of the connector; and a process of connecting, to the connection substrate, parts of the first contact group and the second contact group that are protruded from the insulating member in a direction in which the connection connector is inserted into the connector between the protruding parts as seen from the thickness direction of the connector.

According to the present disclosure, it is possible to provide a connector, a connector unit, and a method for connecting to a connection substrate in the connector that contribute to improving signal transmission characteristics.

The above and other objects, features and advantages of the present disclosure will become more fully understood from the detailed description given hereinbelow and the accompanying drawings.

### BRIEF DESCRIPTION OF DRAWINGS

Fig. 1 is a perspective view showing a connector unit according to a first embodiment as seen from a positive side of a Z-axis;
Fig. 2 is a perspective view showing the connector unit according to the first embodiment as seen from a negative side of the Z-axis;
Fig. 3 is a perspective view showing a connector of the connector unit according to the first embodiment as seen from the positive side of the Z-axis;
Fig. 4 is a perspective view showing the connector of the connector unit according to the first embodiment as seen from the negative side of the Z-axis;
Fig. 5 is a diagram showing the connector of the connector unit according to the first embodiment as seen from the positive side of the Z-axis;
Fig. 6 is an exploded perspective view showing the connector unit according to the first embodiment as seen from the positive side of the Z-axis;
Fig. 7 is an exploded perspective view showing the connector unit according to the first embodiment as seen from the negative side of the Z-axis;
Fig. 8 is a perspective view showing a first contact group and a second contact group in a contact assembly of the connector according to the first embodiment as seen from the positive side of the Z-axis;
Fig. 9 is a perspective view showing an insulating member in the contact assembly of the connector according to the first embodiment as seen from the positive side of the Z-axis;
Fig. 10 is a perspective view showing the insulating member in the contact assembly of the connector according to the first embodiment as seen from the negative side of the Z-axis;
Fig. 11 is a perspective view showing a connection substrate of the connector unit according to the first embodiment as seen from the positive side of the Z-axis;
Fig. 12 is a perspective view showing the connection substrate of the connector unit according to the first embodiment as seen from the negative side of the Z-axis;
Fig. 13 is an enlarged perspective view showing a state in which an engaged part of the connector and an engaging part of the connection substrate are engaged with each other in the connector unit according to the first embodiment as seen from the negative side of the Z-axis;
Fig. 14 is a partially cross-sectional view showing a state in which the engaged part of the connector and the engaging part of the connection substrate are engaged with each other in the connector unit according to the first embodiment as seen from the positive side of the Z-axis;
Fig. 15 is a perspective view showing a connector unit according to a second embodiment as seen from a positive side of a Z-axis;
Fig. 16 is a diagram of the connector unit according to the second embodiment as seen from the positive side of the Z-axis;
Fig. 17 is a partially cross-sectional view showing a state in which an engaged part of a connector and an engaging part of a connection substrate are engaged with each other in the connector unit according to the second embodiment as seen from the positive side of the Z-axis;
Fig. 18 is an exploded perspective view showing the connector of the connector unit according to the second embodiment as seen from the positive side of the Z-axis;
Fig. 19 is a perspective view showing a contact assembly of the connector in the connector unit according to the second embodiment as seen from the positive side of the Z-axis;
Fig. 20 is a perspective view showing the contact assembly of the connector in the connector unit according to the second embodiment as seen from a negative side of the Z-axis;
Fig. 21 is a perspective view showing a connection substrate of the connector unit according to the second embodiment as seen from the positive side of the Z-axis;
Fig. 22 is a diagram showing a state in which a releasing part of the connector is pushed in the connector unit according to the second embodiment as seen from the positive side of the Z-axis;
Fig. 23 is a partially cross-sectional view showing an engaging state in which the engaged part of the connector and the engaging part of the connection substrate are engaged with each other in the state shown in Fig. 22 as seen from the positive side of the Z-axis;
Fig. 24 is a diagram showing a state in which the releasing part of the connector is further pushed in the connector unit according to the second embodiment as seen from the positive side of the Z-axis;
Fig. 25 is a partially cross-sectional view showing the engaging state in which the engaged part of the connector and the engaging part of the connection substrate are engaged with each other in the state shown in Fig. 24 as seen from the positive side of the Z-axis; and

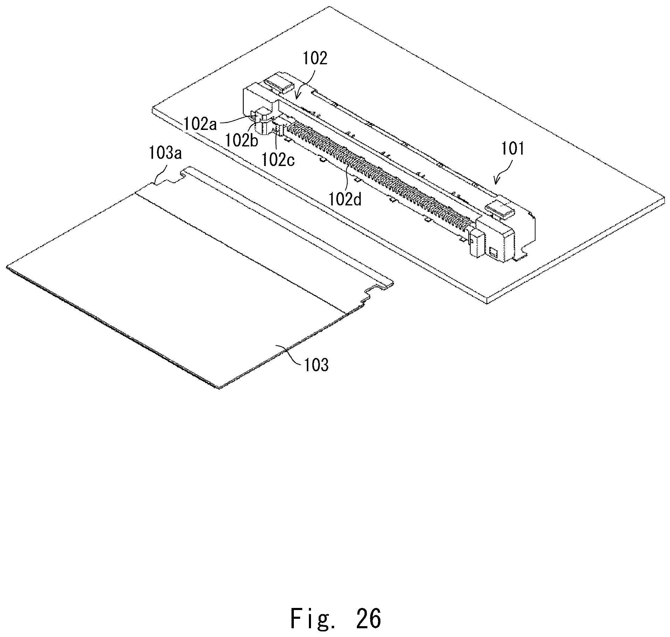

Fig. 26 is a diagram showing Fig. 1 of Patent Literature 1.

### DESCRIPTION OF EMBODIMENTS

Hereinafter, with reference to the drawings, specific embodiments to which the present disclosure is applied will be described in detail. Note that the present disclosure is not limited to the following embodiments. Further, for the sake of clarity of the description, the following descriptions and the drawings are simplified as appropriate. In the following description, a three-dimensional (XYZ) coordinate system is used to clarify the explanation.

<First Embodiment>

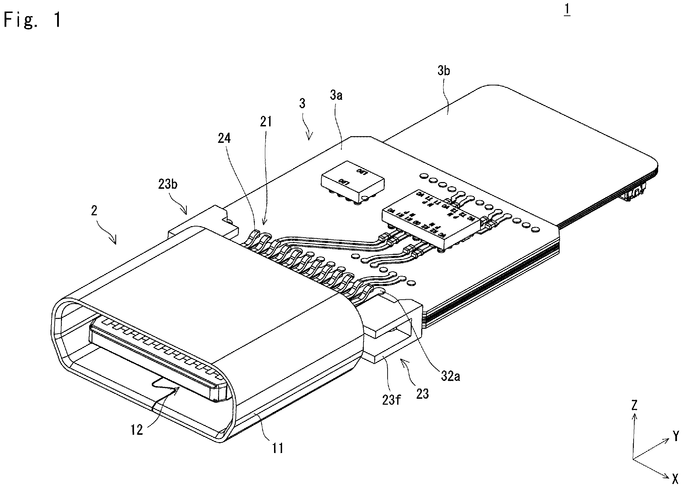

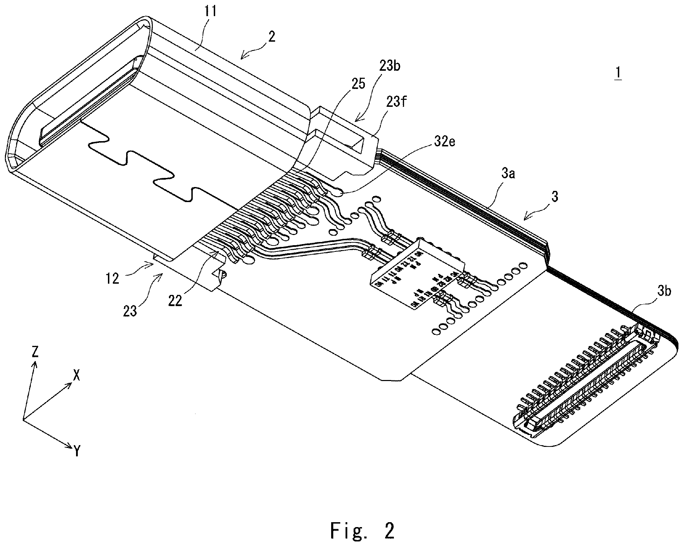

First, a configuration of a connector unit according to this embodiment will be described. Fig. 1 is a perspective view showing the connector unit according to this embodiment as seen from a positive side of a Z-axis. Fig. 2 is a perspective view showing the connector unit according to this embodiment as seen from a negative side of the Z-axis. As shown in Figs. 1 and 2, a connector unit 1 includes, for example, a connector 2 and a connection substrate 3.

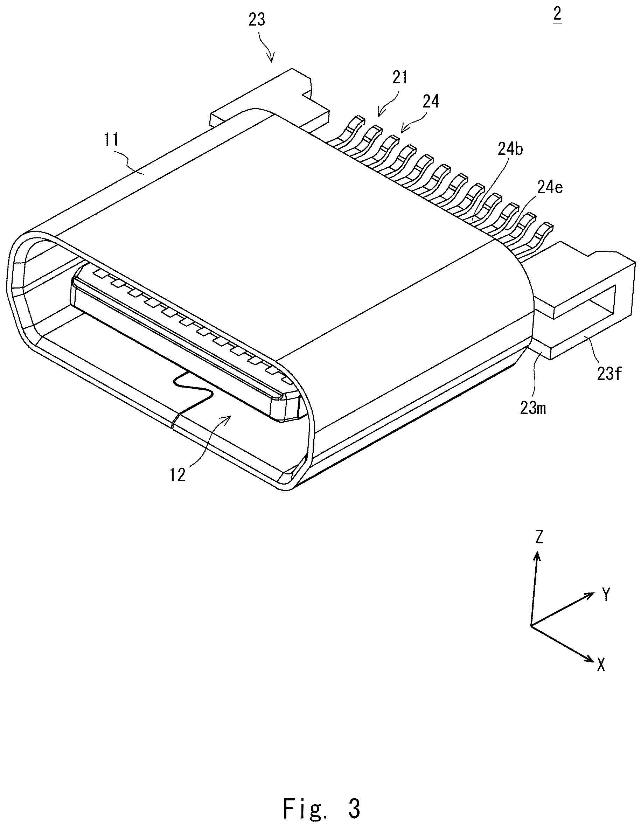

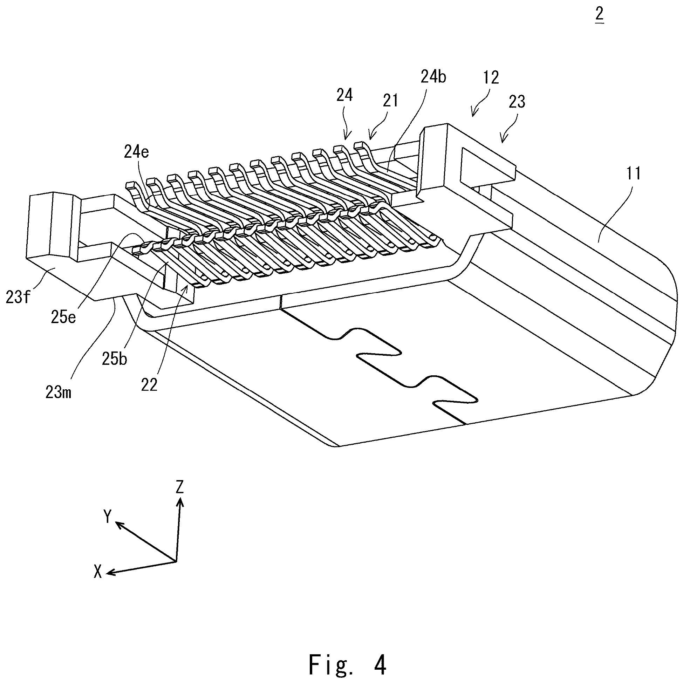

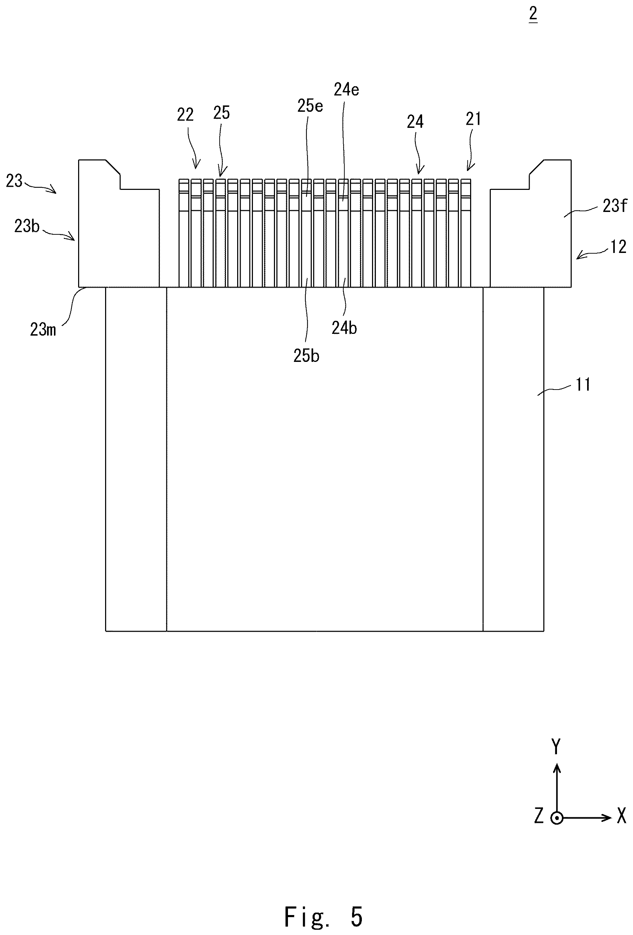

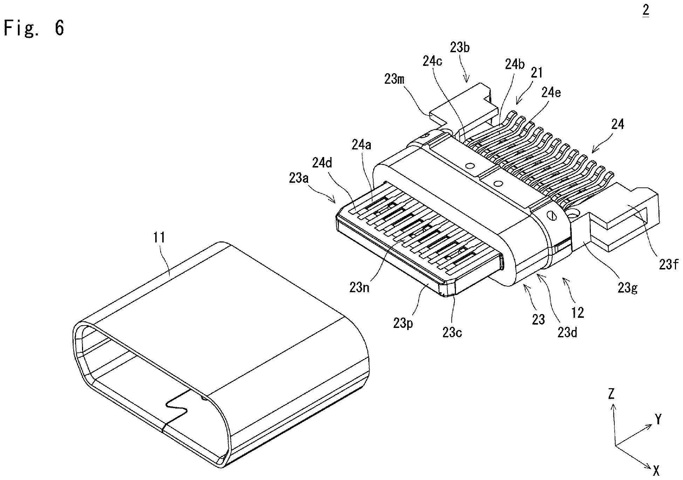

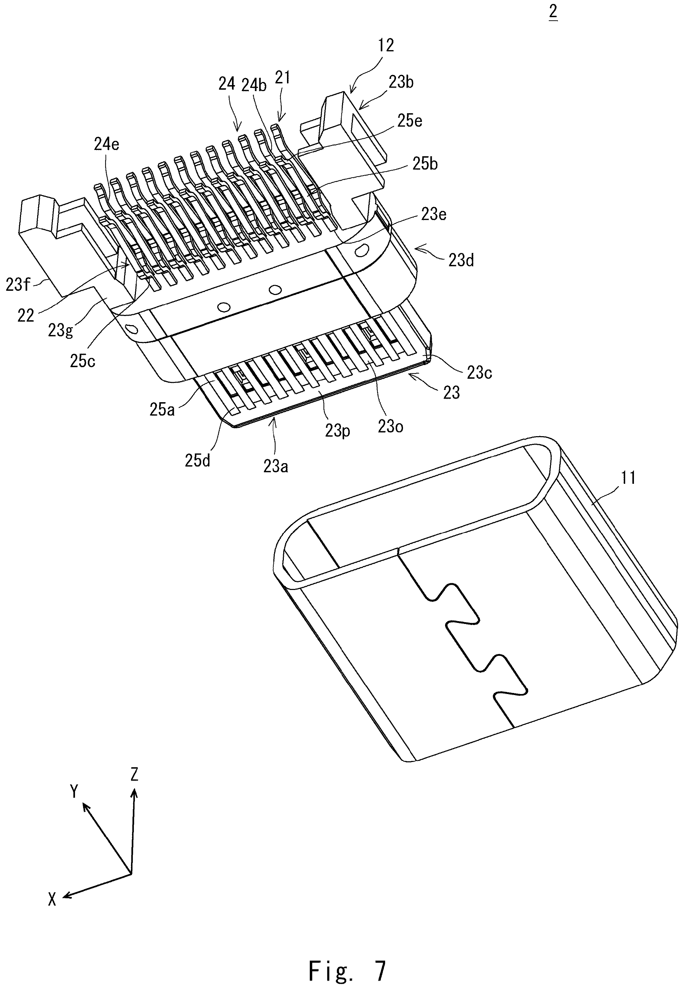

Fig. 3 is a perspective view showing the connector of the connector unit according to this embodiment as seen from the positive side of the Z-axis. Fig. 4 is a perspective view showing the connector of the connector unit according to this embodiment as seen from the negative side of the Z-axis. Fig. 5 is a diagram of the connector of the connector unit according to this embodiment as seen from the positive side of the Z-axis. Fig. 6 is an exploded perspective view showing the connector unit according to this embodiment as seen from the positive side of the Z-axis. Fig. 7 is an exploded perspective view showing the connector unit according to this embodiment as seen from the negative side of the Z-axis.

The connector 2 connects, for example, a connection connector (not shown) to the connection substrate 3. In each drawing, the X-axis direction corresponds to a width direction of the connector unit 1, the Y-axis direction corresponds to a direction in which the connection connector is inserted and removed, and the Z-axis direction corresponds to a thickness (height) direction of the connector unit 1.

As shown in Figs. 3 to 7, the connector 2 includes a shell 11 and a contact assembly 12. The shell 11 is formed of a conductive member. The shell 11 has, for example, a substantially tubular shape, and extends in the Y-axis direction. The shell 11 has, for example, a substantially rectangular shape that is long in the X-axis direction as seen from the Y-axis direction.

As shown in Figs. 3 to 5, the contact assembly 12 is inserted into the shell 11. As shown in Figs. 6 and 7, the contact assembly 12 includes a first contact group 21, a second contact group 22, and an insulating member 23.

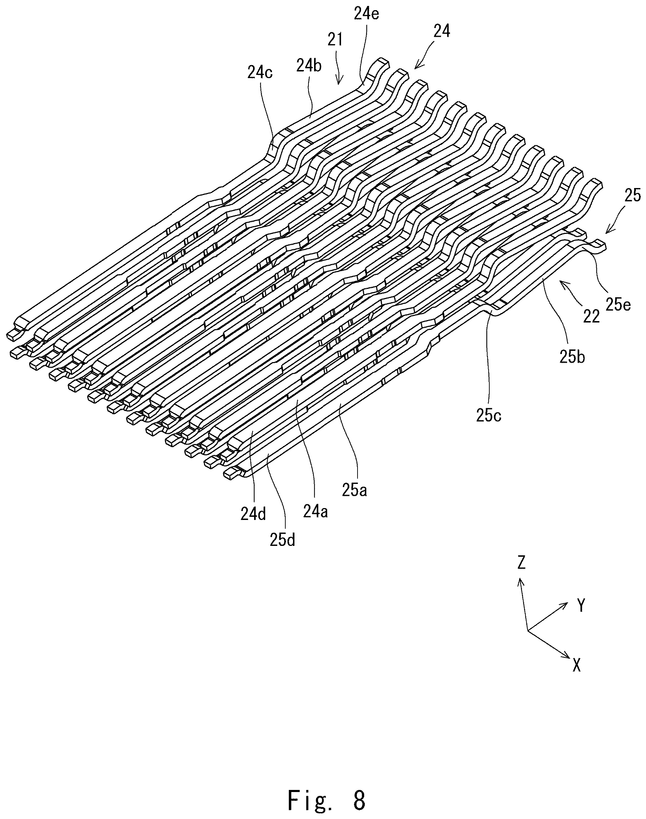

Fig. 8 is a perspective view showing the first contact group and the second contact group in the contact assembly of the connector according to this embodiment as seen from the positive side of the Z-axis. As shown in Fig. 8, the first contact group 21 includes a plurality of contacts 24.

As shown in Fig. 8, the contacts 24 are disposed in such a way that they are spaced apart from each other in the X-axis direction. The contacts 24 are, for example, substantially Z-shaped compression contacts as seen from the X-axis direction, and each of the contacts 24 includes a first part 24a, a second part 24b, and a third part 24c.

As shown in Fig. 8, the first part 24a extends in the Y-axis direction. A part on the negative side of the Y-axis of the first part 24a forms a first electric contact 24d connected to a contact of the connection connector.

As shown in Fig. 8, for example, the second part 24b is inclined in the negative direction of the Z-axis toward the positive side of the Y-axis. As shown in Fig. 1, the part on the positive side of the Y-axis of the second part 24b forms a second electric contact 24e connected to a pad 32a (see Fig. 1) formed on a surface on the positive side of the Z-axis of the connection substrate 3.

As shown in Fig. 8, for example, the second electric contact 24e is bent in a substantially Z-shape as seen from the X-axis direction, and its end part on the positive side of the Y-axis is disposed on the positive side of the Z-axis with respect to its end part on the negative side of the Y-axis. The third part 24c, which extends, for example, in the Z-axis direction, couples the end part on the positive side of the Y-axis of the first part 24a to the end part on the negative side of the Y-axis of the second part 24b.

As shown in Fig. 8, the second contact group 22 includes a plurality of contacts 25. The contacts 25 have, for example, a plane-symmetrical shape with an XY-plane as a plane of symmetry with respect to the contacts 24 of the first contact group 21, and are disposed in such a way that they are spaced apart from each other in the X-axis direction.

As shown in Fig. 8, the contacts 25 each include a first part 25a including a first electric contact 25d connected to the contact of the connection connector, a second part 25b including a second electric contact 25e connected to a pad 32e (see Fig. 2) formed on a surface on the negative side of the Z-axis of the connection substrate 3, and a third part 25c that couples the first part 25a to the second part 25b.

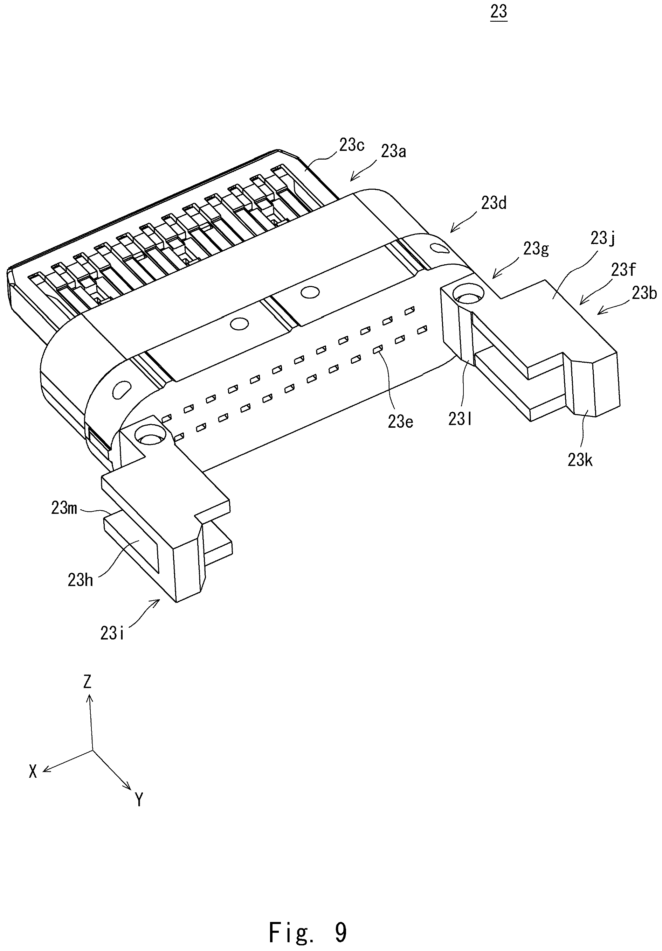

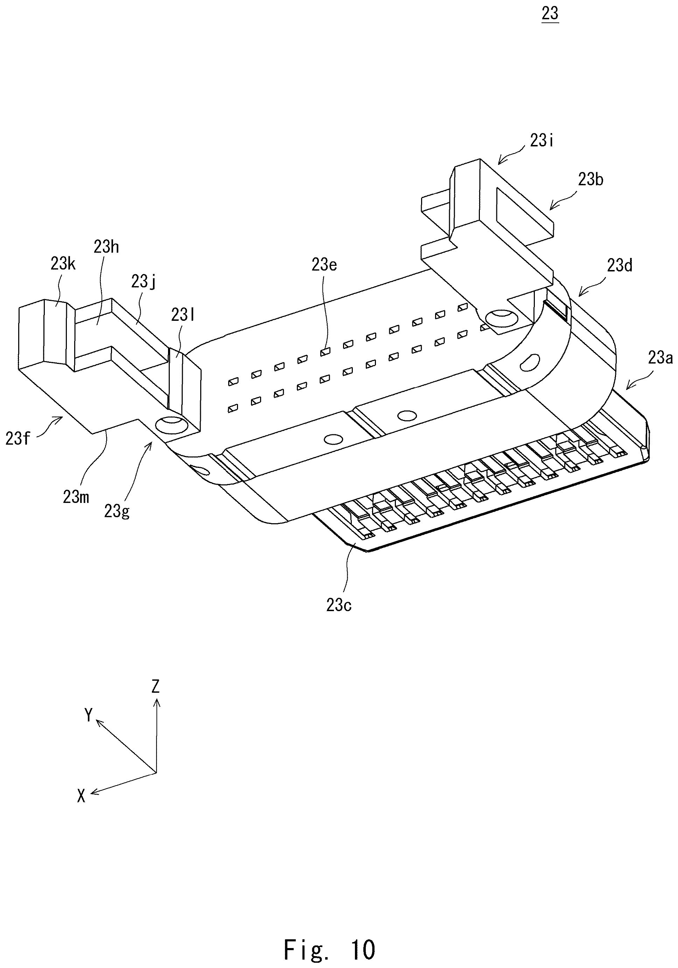

As shown in Figs. 6 and 7, the insulating member 23 is an insulator (housing) that holds the first contact group 21 and the second contact group 22. Fig. 9 is a perspective view showing the insulating member in the contact assembly of the connector according to this embodiment as seen from the positive side of the Z-axis. Fig. 10 is a perspective view showing the insulating member in the contact assembly of the connector according to this embodiment as seen from the negative side of the Z-axis.

As shown in Figs. 9 and 10, the insulating member 23 includes a main body 23a and protruding parts 23b. The main body 23a includes a first part 23c and a second part 23d. The first part 23c has, for example, a flat plate shape that is substantially parallel to the XY-plane, and has a substantially rectangular shape that is long in the X-axis direction as seen from the Y-axis direction.

As shown in Figs. 9 and 10, the first part 23c extends in the Y-axis direction. The first part 23c has a shape corresponding to the shape of the insulating member of the connection connector in such a way that the insulating member that holds the contact in the connection connector can mate with the first part 23c.

As shown in Fig. 6, the first parts 24a of the contacts 24 of the first contact group 21 are exposed from the surface on the positive side of the Z-axis of the first part 23c. Further, as shown in Fig. 7, the first parts 25a of the contacts 25 of the second contact group 22 are exposed from the surface on the negative side of the Z-axis of the first part 24a.

As shown in Figs. 9 and 10, the second part 23d is disposed on the positive side of the Y-axis with respect to the first part 23c, and is connected to the first part 23c. The second part 23d has, for example, a substantially rectangular shape that is long in the X-axis direction as seen from the Y-axis direction, and has an outer shape that is substantially equal to the inner shape of the shell 11.

As shown in Figs. 9 and 10, the second part 23d has a thickness in the Y-axis direction. The second part 23d is protruded on the outward of the insulating member 23 with respect to the first part 23c as seen from the Y-axis direction. The second part 23d includes a plurality of penetrating parts 23e.

The penetrating parts 23e extend in the Y-axis direction, and as shown in Fig. 7, the first parts 24a of the contacts 24 of the first contact group 21 and the first parts 25a of the contacts 25 of the second contact group 22 are made to pass therethrough. That is, the contacts 24 of the first contact group 21 and the contacts 25 of the second contact group 22 are aligned in the second part 23d.

As shown in Figs. 6 and 7, a part on the positive side of the Y-axis including the third parts 24c of the contacts 24 in the first contact group 21 and a part on the positive side of the Y-axis including the third parts 25c of the contacts 25 in the second contact group 22 are protruded on the positive side of the Y-axis from the second part 23d.

As shown in Figs. 9 and 10, the protruding parts 23b are protruded on the positive side of the Y-axis from the end part on the positive side of the X-axis and the end part on the negative side of the X-axis of the second part 23d of the main body 23a. The protruding parts 23b each include an engaged part 23f and an elastic deformation part 23g.

As shown in Figs. 1 and 2, engaging parts 3d of the connection substrate 3 are engaged with the engaged parts 23f. As shown in Figs. 9 and 10, the engaged parts 23f each include an insert-receiving part 23h and a stopper part 23i. The insert-receiving part 23h is, for example, a groove formed of two plate parts 23j spaced apart from each other in the Z-axis direction.

As shown in Figs. 9 and 10, for example, the plate parts 23j have a substantially rectangular shape that is long in the Y-axis direction as seen from the Z-axis direction, and are disposed to be substantially parallel to the XY-plane. The gap between the plate parts 23j in the Z-axis direction, that is, the height of the insert-receiving part 23h in the Z-axis direction, is substantially equal to the thickness of a rigid flexible substrate part 3a of the connection substrate 3 in the Z-axis direction.

As shown in Figs. 9 and 10, the stopper parts 23i are disposed so as to block parts of the end parts on the positive side of the Y-axis of the insert-receiving parts 23h. The stopper parts 23i are protruded on the positive side of the Y-axis from the end parts on the outer side of the insulating member 23 in the X-axis direction in the plate part 23j. The stopper parts 23i have, for example, a substantially rectangular shape as seen from the Z-axis direction, and has a thickness in the Z-axis direction.

As shown in Figs. 9 and 10, the stopper parts 23i each connect the plate part 23j on the positive side of the Z-axis to the plate part 23j on the negative side of the Z-axis. The stopper parts 23i each include an inclined part 23k in a corner part on the inner side of the insulating member 23 in the X-axis direction on the positive side of the Y-axis of the stopper part 23i. The inclined part 23k is inclined on the outward of the insulating member 23 in the X-axis direction toward the positive side of the Y-axis.

As shown in Figs. 9 and 10, the elastic deformation parts 23g connect the engaged parts 23f to the main body 23a, and are elastically deformable in the X-axis direction with respect to the main body 23a. The elastic deformation parts 23g have, for example, a substantially rectangular shape as seen from the Z-axis direction, and have a thickness in the Z-axis direction. The elastic deformation parts 23g each include an inclined part 231 in a corner part on the inner side of the insulating member 23 in the X-axis direction on the positive side of the Y-axis of the elastic deformation part 23g.

As shown in Figs. 9 and 10, the inclined part 231 is inclined on the outward of the insulating member 23 in the X-axis direction toward the positive side of the Y-axis as seen from the Z-axis direction. Then, the inclined part 23l is substantially continuous with a side on the inner side of the insulating member 23 in the X-axis direction in the plate part 23j as seen from the Z-axis direction.

As shown in Figs. 9 and 10, the engaged part 23f and the elastic deformation part 23g form a cutout 23m on the outer side of the insulating member 23 with respect to the elastic deformation part 23g in the X-axis direction on the negative side of the Y-axis with respect to the engaged part 23f. The cutout 23m has, for example, a substantially rectangular shape as seen from the Z-axis direction.

As shown in Figs. 6 and 7, in the space formed of the main body 23a and the protruding parts 23b, the part on the positive side of the Y-axis including the third parts 24c of the contacts 24 in the first contact group 21 and the part on the positive side of the Y-axis including the third parts 25c of the contacts 25 in the second contact group 22 are disposed to be protruded from the main body 23a on the positive side of the Y-axis, as seen from the Z-axis direction.

That is, as shown in Figs. 6 and 7, the part on the positive side of the Y-axis including the third parts 24c of the contacts 24 in the first contact group 21 and the part on the positive side of the Y-axis including the third parts 25c of the contacts 25 in the second contact group 22 are disposed between the protruding parts 23b.

At this time, as shown in Figs. 6 and 7, the part on the positive side of the Y-axis including the third part 24c of each of the contacts 24 in the first contact group 21 and the part on the positive side of the Y-axis including the third part 25c of each of the contacts 25 in the second contact group 22 are not surrounded by the insulating member 23.

As shown in Figs. 6 and 7, the insulating member 23 may be divided into a first insulating member 23n that holds the first contact group 21, a second insulating member 23o that holds the second contact group 22, and a third insulating member 23p that holds the first insulating member 23n and the second insulating member 23o.

The above contact assembly 12 is held in the shell 11, as shown in Figs. 3 to 5, as the contact assembly 12 is inserted into the shell 11 from the positive side of the Y-axis toward the negative side of the Y-axis. At this time, the shell 11 is inserted into the cutout 23m of the insulating member 23 in the contact assembly 12, and the shell 11 contacts the engaged parts 23f of the insulating member 23 of the contact assembly 12.

Then, as shown in Figs. 3 to 5, the second parts 24b of the contacts 24 of the first contact group 21, the second parts 25b of the contacts 25 of the second contact group 22, and the engaged parts 23f of the insulating member 23 protrude from the shell 11 toward the positive side of the Y-axis.

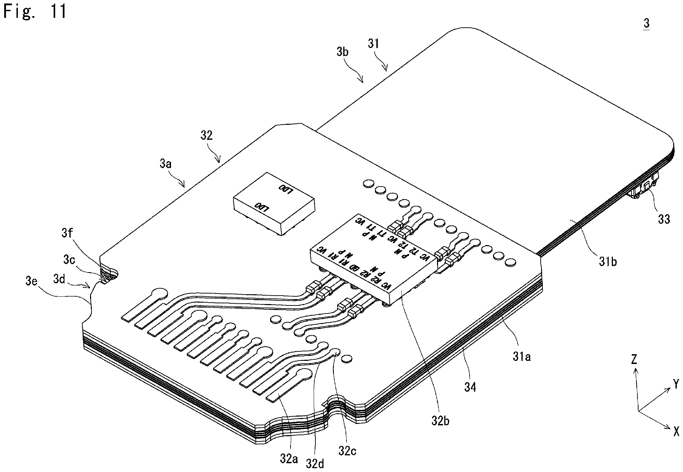

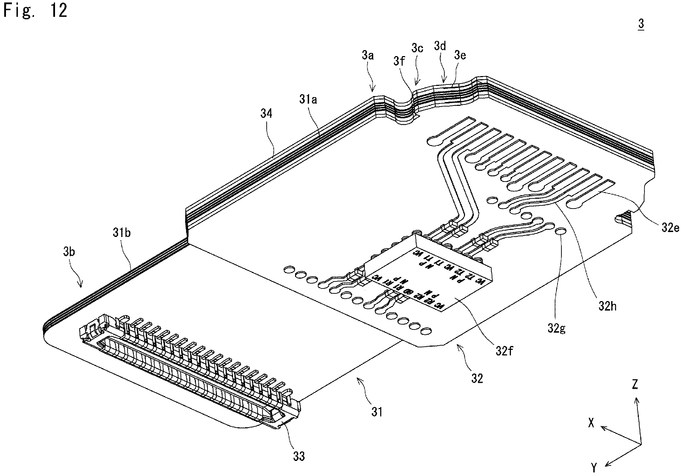

The connection substrate 3 is connected, for example, to a main board or the like of electronic equipment on which a Central Processing Unit (CPU) and the like are mounted. Fig. 11 is a perspective view showing the connection substrate of the connector unit according to this embodiment as seen from the positive side of the Z-axis. Fig. 12 is a perspective view showing the connection substrate of the connector unit according to this embodiment as seen from the negative side of the Z-axis.

As shown in Figs. 11 and 12, the connection substrate 3 includes a flexible substrate 31 and rigid substrates 32. The flexible substrate 31 includes, for example, wires formed on a thin film made of polyimide, etc. The flexible substrate 31 includes a first part 31a and a second part 31b.

As shown in Figs. 11 and 12, the first part 31a has a substantially rectangular shape as seen from the Z-axis direction. The second part 31b is disposed on the positive side of the Y-axis with respect to the first part 31a, and has, for example, a substantially rectangular shape that is smaller than the first part 31a as seen from the Z-axis direction.

As shown in Fig. 12, the second part 31b includes pads (not shown) on the surface on the negative side of the Z-axis of the second part 31b. Then, for example, a connector 33 to be connected to a connector fixed to the main board or the like of electrical equipment is connected to the pads.

As shown in Figs. 11 and 12, the rigid substrates 32 have a rigidity higher than that of the flexible substrate 31, and include a base material made of Flame Retardant Type 4 (FR4) or the like. The rigid substrates 32 are disposed so as to sandwich the first part 31a of the flexible substrate 31 in the Z-axis direction, and are fixed to the first part 31a of the flexible substrate 31 via an insulating adhesive member 34.

As shown in Fig. 11, for example, the rigid substrate 32 on the positive side of the Z-axis includes pads 32a, an equalizer 32b, and vias 32c. The pads 32a are disposed on the surface on the positive side of the Z-axis of the rigid substrate 32 on the positive side of the Z-axis, and are connected to the contacts 24 of the first contact group 21 of the connector 2.

As shown in Fig. 11, the equalizer 32b is mounted on the surface on the positive side of the Z-axis of the rigid substrate 32 on the positive side of the Z-axis, and amplifies a signal input to the pads 32a. The vias 32c connect the pads 32a to wires of the flexible substrate 31 through wires 32d.

As shown in Fig. 12, the rigid surface 32 on the negative side of the Z-axis includes pads 32e, an equalizer 32f, vias 32g, and wires 32h. The detailed description of the rigid surface 32 on the negative side of the Z-axis will be omitted since it has a configuration substantially equal to that of the rigid substrate 32 on the positive side of the Z-axis.

As shown in Figs. 11 and 12, in the above connection substrate 3, a part in which the first part 31a of the flexible substrate 31 is sandwiched by the rigid substrates 32 forms a rigid flexible substrate part 3a, and the second part 31b of the flexible substrate 31 that is protruded on the positive side of the Y-axis from the rigid flexible substrate part 3a forms a flexible substrate part 3b.

As shown in Figs. 11 and 12, the connection substrate 3 includes cutouts 3c and engaging parts 3d in the rigid flexible substrate part 3a. The cutouts 3c cut out both corner parts on the negative side of the Y-axis of the rigid flexible substrate part 3a.

As shown in Figs. 11 and 12, the cutouts 3c have, for example, a substantially right trapezoidal shape having oblique sides that are inclined on the inward of the rigid flexible substrate part 3a in the X-axis direction toward the negative side of the Y-axis as seen from the Z-axis direction in end parts on the inner side of the rigid flexible substrate part 3a in the cutouts 3c.

As shown in Figs. 11 and 12, the engaging parts 3d are protruded on the outward of the rigid flexible substrate part 3a from the end parts on the inner side of the rigid flexible substrate part 3a in the X-axis direction in the cutouts 3c.

As shown in Figs. 11 and 12, the engaging parts 3d have a substantially right-angled triangle shape having oblique sides that are inclined on the inward of the rigid flexible substrate part 3a in the X-axis direction toward the negative side of the Y-axis as seen from the Z-axis direction in end parts on the outer side of the rigid flexible substrate part 3a in the engaging parts 3d. That is, the engaging parts 3d each include an inclined part 3e in the end part on the outer side of the rigid flexible substrate part 3a in the X-axis direction.

Next, a flow of manufacturing the connector 2 of the connector unit 1 according to this embodiment will be described. First, the contacts 24 of the first contact group 21 and the contacts 25 of the second contact group 22 are insert-molded into the insulating member 23, thereby forming the contact assembly 12.

At this time, first, the contacts 24 of the first contact group 21 are insert-molded into the first insulating member 23n and held in the first insulating member 23n, and the contacts 25 of the second contact group 22 are insert-molded into the second insulating member 23o and held in the second insulating member 23o.

Then, the first insulating member 23n and the second insulating member 23o may be insert-molded into the third insulating member 23p. Accordingly, they may be insert-molded into the third insulating member 23p in a state in which the contacts 24 of the first contact group 21 and the contacts 25 of the second contact group 22 are accurately aligned.

Next, the contact assembly 12 is inserted into the shell 11 from the positive side of the Y-axis to the negative side of the Y-axis and the shell is caused to hold the contact assembly 12, whereby the connector 2 can be manufactured.

Next, a flow of manufacturing the connection substrate 3 in the connector unit 1 according to this embodiment will be described. The connector 33 is fixed to the flexible substrate 31 and the equalizers 32b and 32f are fixed to the rigid substrate 32 in advance.

Then, the rigid substrates 32 are disposed in such a way that they sandwich the first part 31a of the flexible substrate 31, and are fixed to the first part 31a of the flexible substrate 31 via the adhesive member 34.

Next, the pads 32a of the rigid substrate 32 on the positive side of the Z-axis are connected to wires of the flexible substrate 31 through the vias 32c, and the pads 32e of the rigid substrate 32 on the negative side of the Z-axis are connected to wires of the flexible substrate 31 through the vias 32g, whereby the connection substrate 3 including the rigid flexible substrate part 3a and the flexible substrate part 3b can be manufactured.

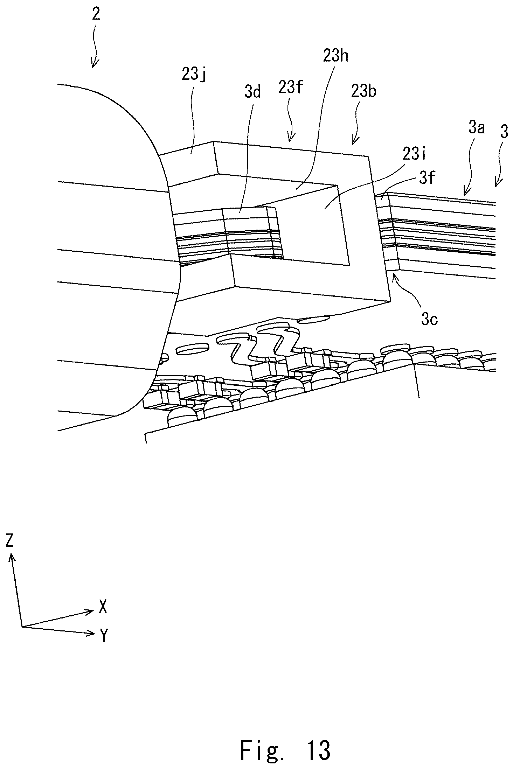

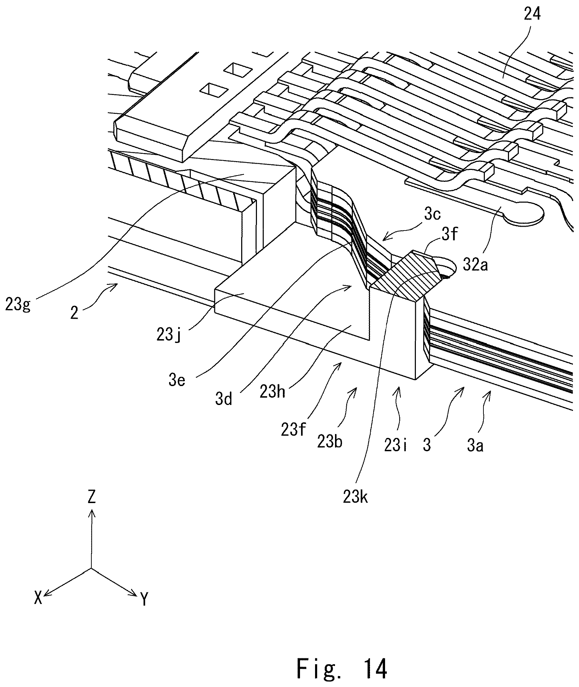

Next, a flow of connecting the connector 2 to the connection substrate 3 in the connector unit 1 according to this embodiment will be described. Fig. 13 is an enlarged perspective view showing a state in which the engaged part of the connector and the engaging part of the connection substrate are engaged with each other as seen from the negative side of the Z-axis in the connector unit according to this embodiment. Fig. 14 is a partially cross-sectional view showing a state in which the engaged part of the connector and the engaging part of the connection substrate are engaged with each other as seen from the positive side of the Z-axis in the connector unit according to this embodiment.

First, the connection substrate 3 is made close to the connector 2 from the positive side of the Y-axis to the negative side of the Y-axis, and the end part on the negative side of the Y-axis of the connection substrate 3 is inserted between the protruding parts 23b of the insulating member 23 in the connector 2. Then, the inclined parts 3e of the engaging parts 3d of the connection substrate 3 are made to contact with the inclined parts 23k of the protruding parts 23b of the insulating member 23 in the connector 2, the elastic deformation parts 23g of the insulating member 23 in the connector 2 are elastically deformed, and the engaged parts 23f are pushed toward the outer side of the connector 2 in the X-axis direction.

At this time, the inclined parts 3e of the engaging parts 3d of the connection substrate 3 and the inclined parts 23k of the protruding parts 23b of the insulating member 23 in the connector 2 are inclined on the inward of the connector unit 1 in the X-axis direction toward the negative side of the Y-axis, whereby the engaged parts 23f of the insulating member 23 in the connector 2 can be easily pushed toward the outer side of the connector unit 1 in the X-axis direction.

That is, the inclined parts 3e of the engaging parts 3d of the connection substrate 3 contact the inclined parts 23k of the protruding parts 23b of the insulating member 23 in the connector 2, whereby a force toward the outer side of the connector unit 1 can be applied to the engaged parts 23f of the insulating member 23 in the connector 2.

The connection substrate 3 is pushed toward the negative side of the Y-axis, and the end part on the negative side of the Y-axis of the connection substrate 3 is inserted between the second parts 24b of the contacts 24 of the first contact group 21 and the second parts 25b of the contacts 25 of the second contact group 22 in the connector 2.

At this time, when the elastic deformation parts 23g of the insulating member 23 in the connector 2 include the inclined parts 231, it is possible to prevent or reduce the end parts on the negative side of the Y-axis of the connection substrate 3 from interfering with the protruding parts 23b of the insulating member 23 in the connector 2.

Accordingly, as shown in Figs. 13 and 14, the engaging part 3d of the connection substrate 3 passes over the stopper part 23i of the insulating member 23 in the connector 2 on the negative side of the Y-axis and is inserted into the insert-receiving part 23h, and the engaging part 3d of the connection substrate 3 is engaged with the space formed by the elastic deformation part 23g, the two plate parts 23j, and the stopper part 23i of the insulating member 23 in the connector 2.

Further, as shown in Figs. 13 and 14, the stopper part 23i of the insulating member 23 in the connector 2 is engaged with the recessed part 3f on the positive side of the Y-axis with respect to the engaging part 3d in the cutout 3c of the connection substrate 3.

At this time, as shown in Fig. 14, the end part on the positive side of the Y-axis of the cutout 3c and the end part on the positive side of the Y-axis of the engaging part 3d in the connection substrate 3 sandwich the stopper part 23i of the insulating member 23 in the connector 2 in the Y-axis direction. Accordingly, the position of the connection substrate 3 in the Y-axis direction with respect to the connector 2 is fixed.

Further, as shown in Fig. 13, the height of the insert-receiving part 23h of the insulating member 23 in the Z-axis direction in the connector 2 is substantially equal to the thickness of the rigid flexible substrate part 3a of the connection substrate 3 in the Z-axis direction, and the two plate parts 23j of the insulating member 23 of the connector 2 sandwich the connection substrate 3. Accordingly, the position of the connection substrate 3 in the Z-axis direction with respect to the connector 2 is fixed.

Further, as shown in Fig. 14, the stopper part 23i of the insulating member 23 in the connector 2 comes into substantial contact with the recessed part 3f on the positive side of the Y-axis with respect to the engaging part 3d in the cutout 3c of the connection substrate 3, and the stopper parts 23i of the insulating member 23 in the connector 2 sandwich the connection substrate 3 in the X-axis direction.

That is, the stopper part 23i of the insulating member 23 in the connector 2 functions as a contacting part that is in contact with the connection substrate 3. Accordingly, the position of the connection substrate 3 in the X-axis direction with respect to the connector 2 is fixed.

At the same time, as shown in Fig. 1, the second electric contacts 24e of the contacts 24 of the first contact group 21 in the connector 2 are connected to the pads 32a of the rigid substrate 32 on the positive side of the Z-axis in the connection substrate 3.

Further, the second electric contacts 25e of the contacts 25 of the second contact group 22 in the connector 2 are connected to the pads 32e of the rigid substrate 32 on the negative side of the Z-axis in the connection substrate 3. Accordingly, the connector 2 can be connected to the connection substrate 3 while engaging the engaged parts 23f of the connector 2 with the engaging parts 3d of the connection substrate 3. That is, the connector 2 and the connection substrate 3 are connected to each other by solderless means.

The connection connector can be connected to the aforementioned connector unit 1 in a state in which, for example, the connector 33 of the connection substrate 3 is connected to a connector fixed to a main board or the like of electrical equipment. For example, the connection connector is inserted into the shell 11 of the connector 2 from the negative side of the Y-axis toward the positive side of the Y-axis.

Then, the contacts of the connection connector are connected to the first electric contacts 24d of the contacts 24 of the first contact group 21 and the first electric contacts 25d of the contacts 25 of the second contact group 22 in the connector 2. Accordingly, the connection connector can be connected to the connector 2 of the connector unit 1.

Next, a flow of replacing the connector 2 or the connection substrate 3 by another one in the connector unit 1 according to this embodiment will be described. In the connector unit 1 according to this embodiment, the engaged parts 23f of the connector 2 are engaged with the engaging parts 3d of the connection substrate 3, whereby the connector 2 and the connection substrate 3 are connected to each other.

Therefore, by releasing the engaging state of the engaged parts 23f of the connector 2 and the engaging parts 3d of the connection substrate 3, the connector 2 or the connection substrate 3 can be replaced by another one. In particular, when the connector 2 and the connection substrate 3 are connected to each other by solderless means, the connector 2 or the connection substrate 3 can be easily replaced by another one.

As described above, in the connector 2, the connector unit 1, and the method for connecting to the connection substrate 3 in the connector 2 according to this embodiment, the part on the positive side of the Y-axis including the third parts 24c of the contacts 24 in the first contact group 21 and the part on the positive side of the Y-axis including the third parts 25c of the contacts 25 in the second contact group 22 are disposed between the protruding parts 23b in such a way that they are protruded from the main body 23a of the insulating member 23 on the positive side of the Y-axis as seen from the Z-axis direction.

That is, the part on the positive side of the Y-axis including the third part 24c of each of the contacts 24 in the first contact group 21 and the part on the positive side of the Y-axis including the third part 25c of each of the contacts 25 in the second contact group 22 are not surrounded by the insulating member 23. Therefore, it is possible to prevent or reduce a decrease in impedance, which can contribute to improving signal transmission characteristics.

In addition, in the connector 2, the connector unit 1, and the method for connecting to the connection substrate 3 in the connector 2 according to this embodiment, the engaging parts 3d of the connection substrate 3 are engaged with the engaged parts 23f of the insulating member 23 in the connector 2, whereby the connector 2 and the connection substrate 3 can be connected to each other.

At this time, the end parts on the positive side of the Y-axis of the cutouts 3c and the end parts on the positive side of the Y-axis of the engaging parts 3d in the connection substrate 3 sandwich the stopper parts 23i of the insulating member 23 in the connector 2 in the Y-axis direction. Accordingly, the position of the connection substrate 3 in the Y-axis direction with respect to the connector 2 can be fixed. Further, the connection substrate 3 is sandwiched by the two plate parts 23j of the insulating member 23 of the connector 2. Accordingly, the position of the connection substrate 3 in the Z-axis direction with respect to the connector 2 can be fixed.

Further, the stopper parts 23i of the insulating member 23 in the connector 2 are in contact with the recessed parts 3f on the positive side of the Y-axis with respect to the engaging parts 3d in the cutouts 3c of the connection substrate 3, and the stopper parts 23i of the insulating member 23 in the connector 2 sandwich the connection substrate 3 in the X-axis direction. Accordingly, the position of the connection substrate 3 in the X-axis direction with respect to the connector 2 can be fixed.

In the connector 2, the connector unit 1, and the method for connecting to the connection substrate 3 in the connector 2 according to this embodiment, the engaged parts 23f of the connector 2 and the engaging parts 3d of the connection substrate 3 are engaged with each other, whereby the connector 2 and the connection substrate 3 are connected to each other. Therefore, when the engaging state of the engaged parts 23f of the connector 2 with the engaging parts 3d of the connection substrate 3 is released, the connector 2 or the connection substrate 3 can be replaced by another one in a simple manner.

When the protruding parts 23b of the insulating member 23 in the connector 2 include the elastic deformation parts 23g in the connector 2, the connector unit 1, and the method for connecting to the connection substrate 3 in the connector 2 according to this embodiment, the engaged parts 23f of the connector 2 are pushed toward the outer side of the connector unit 1 in the X-axis direction by the engaging parts 3d of the connection substrate 3, and the gap between the engaged parts 23f of the connector 2 can be widened in a favorable way. Accordingly, the engaging parts 3d of the connection substrate 3 can be smoothly engaged with the engaged parts 23f of the connector 2.

When the connection substrate 3 includes the inclined parts 3e in the engaging parts 3d and the insulating member 23 in the connector 2 includes the inclined parts 23k in the engaged parts 23f in the connector 2, the connector unit 1, and the method for connecting to the connection substrate 3 in the connector 2 according to this embodiment, the engaged parts 23f of the insulating member 23 in the connector 2 can be easily pushed toward the outer side of the connector unit 1 in the X-axis direction. Accordingly, the engaging parts 3d of the connection substrate 3 can be smoothly engaged with the engaged parts 23f of the insulating member 23 in the connector 2.

When the connector 2 and the connection substrate 3 are connected to each other by solderless means in the connector 2, the connector unit 1, and the method for connecting to the connection substrate 3 in the connector 2 according to this embodiment, it is possible to prevent or reduce a decrease in impedance, which can contribute to improving signal transmission characteristics compared to the case in which the connector 2 and the connection substrate 3 are connected to each other by soldering.

When a part of the connection substrate 3 that is connected to a connector of a main board or the like of electrical equipment is formed of the flexible substrate part 3b in the connector unit 1 according to this embodiment, the connector 33 can be easily connected to the connector of the main board or the like due to flexibility of the flexible substrate part 3b.

### <Second Embodiment>

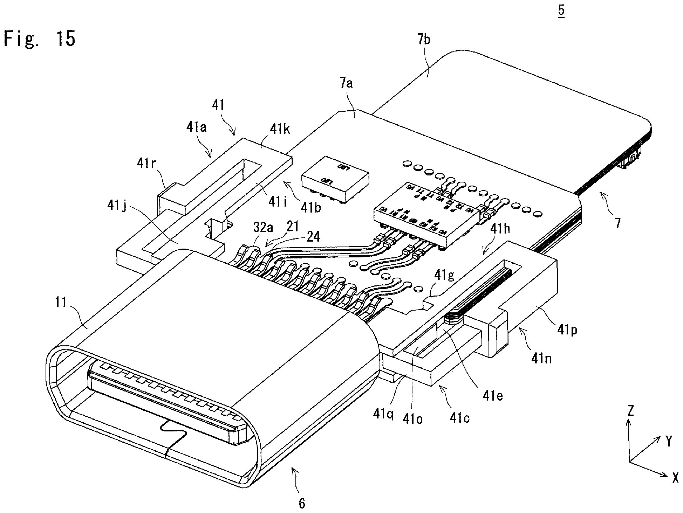

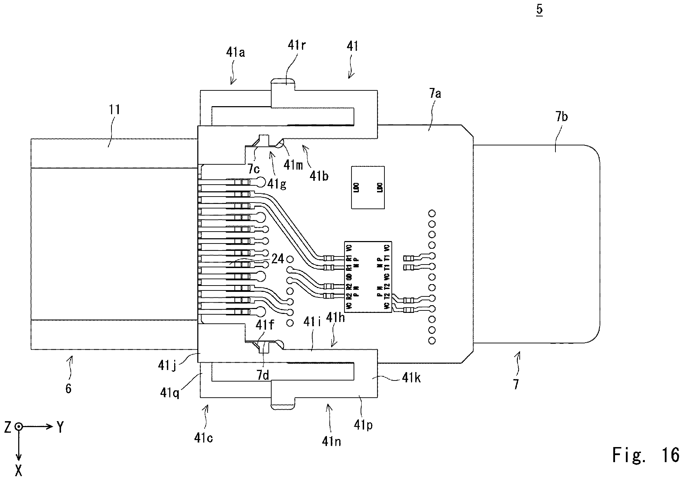

First, a configuration of a connector unit according to this embodiment will be described. Fig. 15 is a perspective view showing the connector unit according to this embodiment as seen from a positive side of a Z-axis. Fig. 16 is a diagram showing the connector unit according to this embodiment as seen from the positive side of the Z-axis.

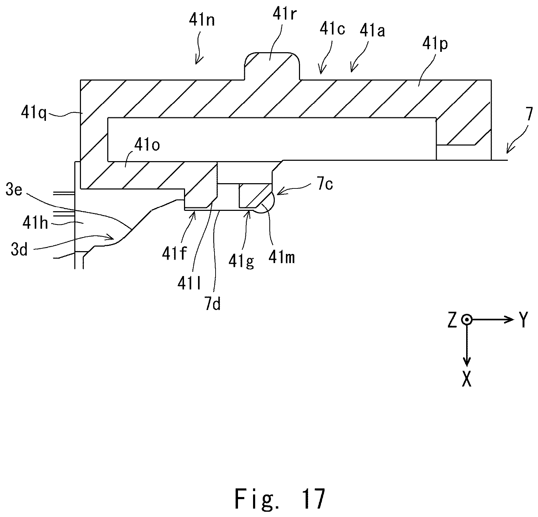

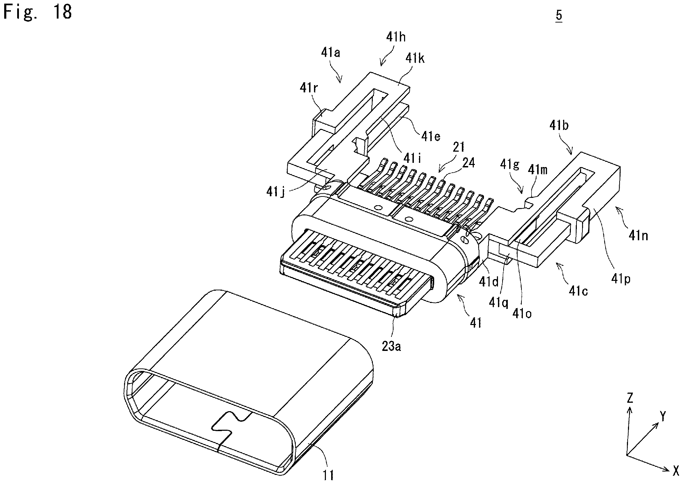

Fig. 17 is a partially cross-sectional view showing a state in which an engaged part of a connector and an engaging part of a connection substrate are engaged with each other in the connector unit according to this embodiment as seen from the positive side of the Z-axis. Fig. 18 is an exploded perspective view showing the connector of the connector unit according to this embodiment as seen from the positive side of the Z-axis.

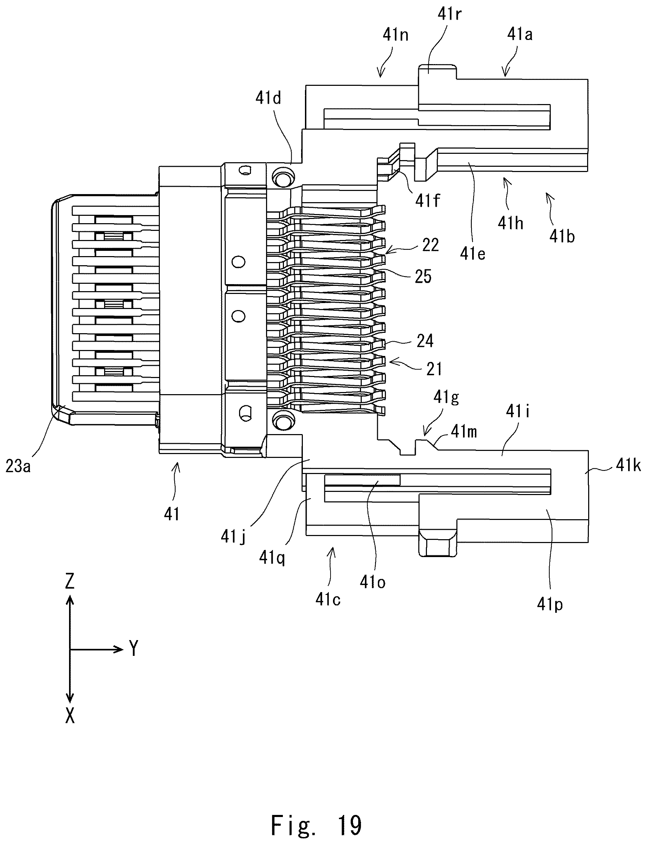

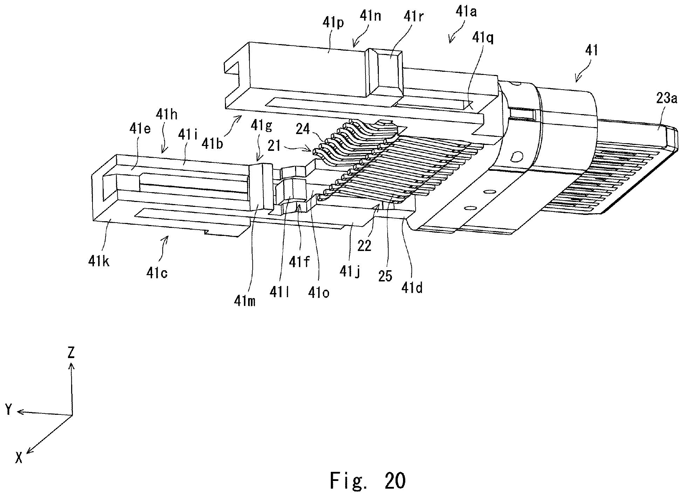

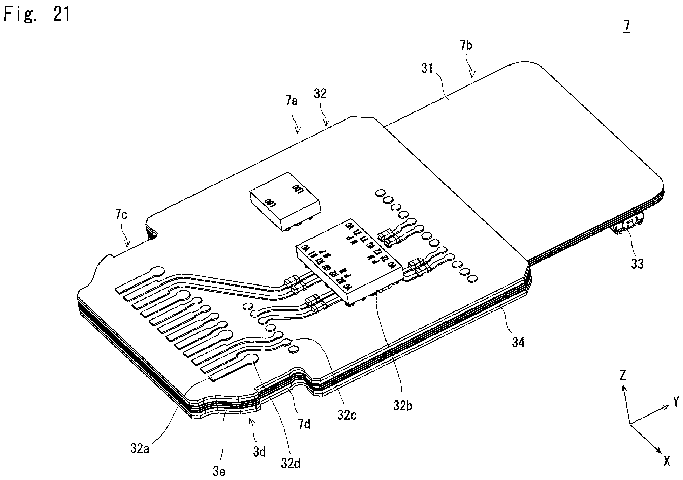

Fig. 19 is a perspective view showing a contact assembly of the connector in the connector unit according to this embodiment as seen from the positive side of the Z-axis. Fig. 20 is a perspective view showing the contact assembly of the connector in the connector unit according to this embodiment as seen from a negative side of the Z-axis. Fig. 21 is a perspective view showing the connection substrate of the connector unit according to this embodiment as seen from the positive side of the Z-axis.

As shown in Figs. 15 to 21, a connector unit 5 according to this embodiment has a configuration substantially equal to that of the connector unit 1 according to the first embodiment except for the configuration of protruding parts 41a and the like of an insulating member 41 in a connector 6 and the shape of cutouts 7c of a connection substrate 7. Therefore, redundant descriptions will be omitted and the same elements are denoted by the same reference symbols in the description.

As shown in Figs. 15 to 20, the protruding parts 41a of the insulating member 41 in the connector 6 each include an engaged part 41b, a releasing part 41c, and an elastic deformation part 41d. The engaged part 41b includes an insert-receiving part 41e, a stopper part 41f, and a contacting part 41g. The insert-receiving part 41e is, for example, a groove formed of two plate parts 41h spaced apart from each other in the Z-axis direction.

As shown in Figs. 18 to 20, for example, the plate parts 41h have a substantially Z-shape as seen from the Z-axis direction, and are disposed to be substantially parallel to the XY-plane. The plate parts 41h each include a first part 41i, a second part 41j, and a third part 41k. The first part 41i extends in the Y-axis direction. The second part 41j extends toward the inner side of the insulating member 41 in the X-axis direction from the end part on the negative side of the Y-axis of the first part 41i.

As shown in Figs. 18 to 20, the third part 41k extends toward the outer side of the insulating member 41 in the X-axis direction from the end part on the positive side of the Y-axis of the first part 41i. As shown in Fig. 15, the gap between the plate parts 41h in the Z-axis direction, that is, the height of the insert-receiving part 41e in the Z-axis direction, is substantially equal to the thickness of a rigid flexible substrate part 7a of the connection substrate 7 in the Z-axis direction.

As shown in Figs. 17 and 20, for example, the stopper parts 41f are each protruded on the inner side of the insulating member 41 in the X-axis direction from the releasing part 41c of the insulating member 41 near a corner part of the first part 41i and the second part 41j of the plate part 41h. The stopper parts 41f are each disposed between the plate part 41h on the positive side of the Z-axis and the plate part 41h on the negative side of the Z-axis as seen from the X-axis direction.

As shown in Fig. 17, the stopper parts 41f each have, for example, a substantially rectangular shape as seen from the Z-axis direction, and has a thickness in the Z-axis direction. At this time, the stopper part 41f may include, at the end part on the positive side of the Y-axis of the stopper part 41f, an inclined part 411 that is inclined on the inward of the insulating member 41 in the X-axis direction toward the negative side of the Y-axis.

As shown in Figs. 15 to 20, the contacting parts 41g are each disposed on the positive side of the Y-axis with respect to the stopper part 41f. The contacting part 41g is protruded on the inner side of the insulating member 41 in the X-axis direction from the plate part 41h of the insulating member 41. The contacting part 41g connects the first part 41i of the plate part 41h on the positive side of the Z-axis to the first part 41i of the plate part 41h on the negative side of the Z-axis.

As shown in Figs. 15 to 20, for example, the contacting part 41g has a substantially rectangular shape as seen from the Z-axis direction, and has a thickness in the Z-axis direction. At this time, the contacting part 41g may include, at the end part on the positive side of the Y-axis of the contacting part 41g, an inclined part 41m that is inclined on the inward of the insulating member 41 in the X-axis direction toward the negative side of the Y-axis.

As shown in Fig. 16, the gap between the end part on the negative side of the X-axis of the contacting part 41g on the positive side of the X-axis and the end part on the positive side of the X-axis of the contacting part 41g on the negative side of the X-axis is substantially equal to a gap between a recessed part 7d on the positive side of the Y-axis with respect to the engaging part 3d in the cutout 7c on the positive side of the X-axis of the connection substrate 7 and the recessed part 7d on the positive side of the Y-axis with respect to the engaging part 3d in the cutout 7c on the negative side of the X-axis of the connection substrate 7.

As shown in Figs. 15 to 20, for example, the releasing parts 41c each include an arm part 41n and a lever part 41o. The arm part 41n has a substantially L shape as seen from the Z-axis direction, and has a thickness in the Z-axis direction. The thickness of a part on the negative side of the Y-axis of the arm part 41n in the Z-axis direction is smaller than the thickness of a part on the positive side of the Y-axis of the arm part 41n in the Z-axis direction in such a way that the part on the negative side of the Y-axis of the arm part 41n can be inserted into the insert-receiving part 41e.

As shown in Figs. 15 to 20, the arm part 41n includes a first part 41p and a second part 41q. The first part 41p extends in the Y-axis direction. The end part on the positive side of the Y-axis of the first part 41p is connected to the end part on the outer side of the insulating member 41 in the X-axis direction of the third part 41k of the plate part 41h in the engaged part 41b.

As shown in Figs. 15 to 20, the first part 41p connects the end part on the positive side of the Y-axis of the plate part 41h on the positive side of the Z-axis to the end part on the positive side of the Y-axis of the plate part 41h on the negative side of the Z-axis. The end part on the negative side of the Y-axis of the first part 41p is disposed, for example, in a position substantially equal to that of the end part on the negative side of the Y-axis of the engaged part 41b in the Y-axis direction.

As shown in Figs. 15 to 20, the second part 41q extends toward the inner side of the insulating member 41 in the X-axis direction from the end part on the negative side of the Y-axis of the first part 41p. The second part 41q is disposed between the plate part 41h on the positive side of the Z-axis and the plate part 41h on the negative side of the Z-axis as seen from the X-axis direction.

The arm part 41n may include a pushing part 41r for enabling a worker to push the arm part 41n toward the inner side of the insulating member 41 in the X-axis direction when the engaging state of the engaged part 41b of the connector 6 with the engaging part 3d of the connection substrate 7 is released, as will be described later.

As shown in Figs. 15 to 20, the pushing part 41r is protruded on the outward of the insulating member 41 from the first part 41p of the arm part 41n in the X-axis direction. The pushing part 41r has, for example, a substantially rectangular shape as seen from the Z-axis direction, and has a thickness in the Z-axis direction.

As shown in Figs. 18 and 19, the lever part 41o extends toward the positive side of the Y-axis from the end part on the inner side of the insulating member 41 in the X-axis direction of the second part 41q of the arm part 41n. The lever part 41o has, for example, a substantially rectangular shape that is long in the Y-axis direction as seen from the X-axis direction, and has a thickness in the X-axis direction.

As shown in Figs. 18 and 19, the lever part 41o is disposed between the second part 41j of the plate part 41h on the positive side of the Z-axis and the second part 41j of the plate part 41h on the negative side of the Z-axis. As shown in Fig. 20, the stopper part 41f is protruded on the inner side of the insulating member 41 in the X-axis direction from the end part on the positive side of the Y-axis of the lever part 41o.

The elastic deformation part 41d is similar to the elastic deformation part 23g of the protruding parts 23b of the insulating member 23 of the connector 2 according to the first embodiment, and connects a main body 23a to the engaged part 41b, as shown in Figs. 18 and 19.

As shown in Fig. 21, the connection substrate 7 has a configuration substantially equal to that of the connection substrate 3 according to the first embodiment, and includes a rigid flexible substrate part 7a and a flexible substrate part 7b. Note that the recessed part 7d of the part on the positive side of the Y-axis with respect to the engaging part 3d in the cutout 7c is longer in the Y-axis direction than the recessed part 3f of the part on the positive side of the Y-axis with respect to the engaging part 3d in the cutout 3c of the connection substrate 3 according to the first embodiment.

Next, a flow of connecting the connector 6 to the connection substrate 7 in the connector unit 5 according to this embodiment will be described. First, the end part on the positive side of the X-axis and the end part on the negative side of the X-axis of the connection substrate 7 are inserted into the part on the positive side of the Y-axis of the insert-receiving parts 41e of the insulating member 41 in the connector 6, and the connection substrate 7 is made close to the connector 6 from the positive side of the Y-axis to the negative side of the Y-axis.

Then, the end part on the negative side of the Y-axis of the connection substrate 7 is inserted between the contacting parts 41g of the insulating member 41 in the connector 6 while making the inclined parts 3e of the engaging parts 3d of the connection substrate 7 contact with the inclined parts 41m of the contacting parts 41g of the insulating member 41 in the connector 6.

Accordingly, when the elastic deformation parts 41d of the insulating member 41 of the connector 6 are elastically deformed and the engaged parts 41b are pushed toward the outer side of the connector 6, and the connection substrate 7 is pushed toward the negative side of the Y-axis, then the engaging parts 3d of the connection substrate 7 pass over the contacting parts 41g on the negative side of the Y-axis.

At this time, the inclined parts 3e of the engaging parts 3d of the connection substrate 7, and the inclined parts 41m of the contacting parts 41g of the insulating member 41 in the connector 6 are inclined on the inward of the connector unit 5 in the X-axis direction toward the negative side of the Y-axis, whereby it is possible to easily push the engaged parts 41b of the insulating member 41 in the connector 6 toward the outer side of the connector unit 5.

The connection substrate 7 is pushed toward the negative side of the Y-axis, the inclined parts 3e of the engaging parts 3d of the connection substrate 7 are made contact with the inclined parts 41l of the stopper parts 41f of the insulating member 41 in the connector 6, the arm parts 41n and the lever parts 41o of the releasing parts 41c of the insulating member 41 in the connector 6 are elastically deformed, and the stopper parts 41f are pushed toward the outer side of the connector 6 in the X-axis direction.

At this time, the inclined parts 3e of the engaging parts 3d of the connection substrate 7, and the inclined parts 411 of the stopper parts 41f of the insulating member 41 in the connector 6 are inclined on the inward of the connector unit 5 in the X-axis direction toward the negative side of the Y-axis, whereby it is possible to easily push the stopper part 41f of the insulating member 41 in the connector 6 toward the outer side of the connector 6.

Then, the connection substrate 7 is pushed toward the negative side of the Y-axis, the end parts on the negative side of the Y-axis of the connection substrate 7 are inserted into parts on the negative side of the Y-axis of the insert-receiving parts 41e of the insulating member 41 in the connector 6 and are inserted between the second parts 24b of the contacts 24 of the first contact group 21 and the second parts 25b of the contacts 25 of the second contact group 22 in the connector 6.

Accordingly, the engaging parts 3d of the connection substrate 7 pass over the stopper parts 41f of the insulating member 41 in the connector 6 on the negative side of the Y-axis, and the engaging parts 3d of the connection substrate 7 are each engaged with the space formed of the two plate parts 41h, the stopper part 41f, and the lever part 41o in the insert-receiving part 41e of the insulating member 41 of the connector 6. At this time, as shown in Fig. 17, the end part on the positive side of the Y-axis of the engaging part 3d of the connection substrate 7 is in contact with the end part on the negative side of the Y-axis of the stopper part 41f of the insulating member 41 in the connector 6.

Further, the contacting parts 41g and the stopper parts 41f of the insulating member 41 in the connector 6 are engaged with the recessed parts 7d on the positive side of the Y-axis with respect to the engaging parts 3d in the cutouts 7c of the connection substrate 7. At this time, the end parts on the positive side of the Y-axis of the cutouts 7c in the connection substrate 7 are in contact with the end parts on the positive side of the Y-axis of the contacting parts 41g of the insulating member 41 in the connector 6. Accordingly, the position in the Y-axis direction of the connection substrate 7 with respect to the connector 6 is fixed.

Further, the gap between two plate parts 41h of the insulating member 41 in the connector 6 in the Z-axis direction is substantially equal to the thickness of the rigid flexible substrate part 7a of the connection substrate 7 in the Z-axis direction, and the two plate parts 41h of the insulating member 41 of the connector 6 sandwich the connection substrate 7. Accordingly, the position of the connection substrate 7 in the Z-axis direction with respect to the connector 6 is fixed.

Further, the contacting parts 41g of the insulating member 41 in the connector 6 are in contact with the recessed parts 7d of the parts on the positive side of the Y-axis with respect to the engaging parts 3d in the cutouts 7c of the connection substrate 7, and the contacting parts 41g of the insulating member 41 in the connector 6 sandwich the connection substrate 7 in the X-axis direction. Accordingly, the position of the connection substrate 7 in the X-axis direction with respect to the connector 6 is fixed.

At the same time, as shown in Figs. 15 and 16, the second electric contacts 24e of the contacts 24 of the first contact group 21 in the connector 6 are connected to the pads 32a of the rigid substrate 32 on the positive side of the Z-axis in the connection substrate 7.

Further, the second electric contacts 25e of the contacts 25 of the second contact group 22 in the connector 6 are connected to the pads 32e of the rigid substrate 32 on the negative side of the Z-axis in the connection substrate 7. Accordingly, the connector 6 can be connected to the connection substrate 7 while engaging the engaged part 41b of the connector 6 with the engaging part 3d of the connection substrate 7.

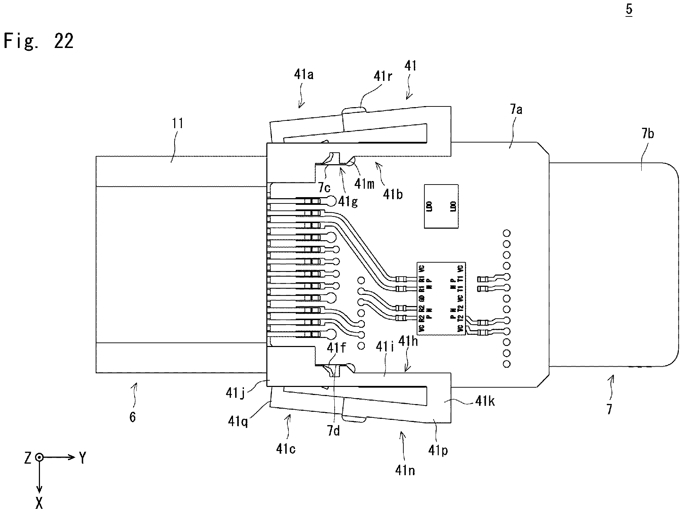

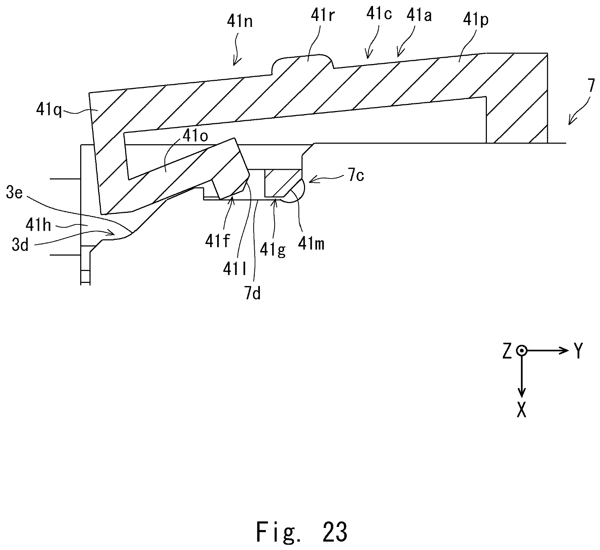

Next, a flow of releasing the engaging state of the engaged part 41b of the connector 6 with the engaging part 3d of the connection substrate 7 in the connector unit 5 according to this embodiment will be described. Fig. 22 is a diagram showing a state in which the releasing part of the connector is pushed in the connector unit according to this embodiment as seen from the positive side of the Z-axis. Fig. 23 is a partially cross-sectional view showing an engaging state in which the engaged part of the connector and the engaging part of the connection substrate are engaged with each other in the state shown in Fig. 22 as seen from the positive side of the Z-axis.

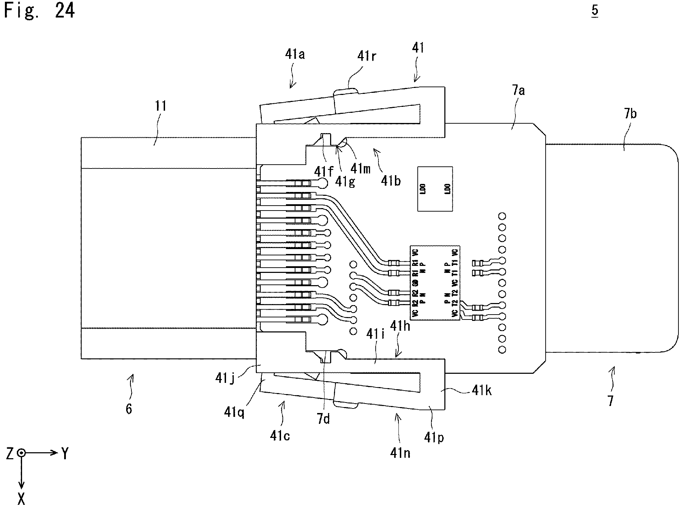

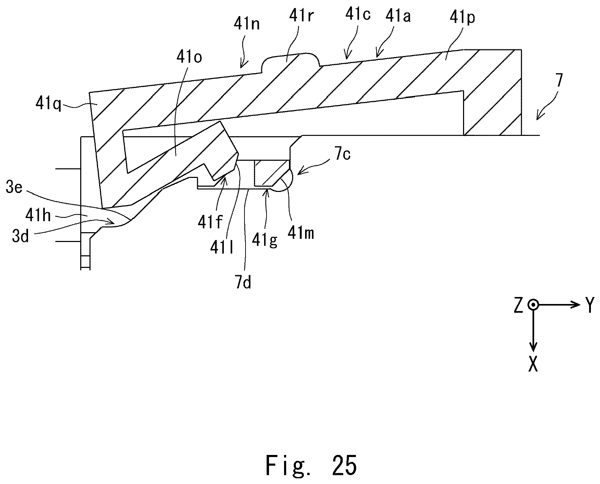

Fig. 24 is a diagram showing a state in which the releasing part of the connector is further pushed in the connector unit according to this embodiment as seen from the positive side of the Z-axis. Fig. 25 is a partially cross-sectional view showing an engaging state in which the engaged part of the connector and the engaging part of the connection substrate are engaged with each other in the state shown in Fig. 24 as seen from the positive side of the Z-axis.

First, as shown in Fig. 22, the releasing part 41c of the connector 6 is pushed toward the inner side of the connector 6 in the X-axis direction. Accordingly, as shown in Fig. 23, the end part on the positive side of the Y-axis of the first part 41p of the arm part 41n of the releasing part 41c is elastically deformed, and the second part 41q of the arm part 41n pushes the end part on the negative side of the Y-axis of the lever part 41o toward the inner side of the connector 6 in the X-axis direction.

Then, as shown in Fig. 23, the lever part 41o of the connector 6 is in contact with the engaging part 3d of the connection substrate 7, and the lever part 41o is rotated in such a way that the stopper part 41f of the connector 6 is away from the engaging part 3d of the connection substrate 7, the contacting part of the lever part 41o of the connector 6 with the engaging part 3d of the connection substrate 7 serving as a supporting point part and the end part on the negative side of the Y-axis of the lever part 41o of the connector 6 serving as an action point part.

Further, when the releasing part 41c of the connector 6 is pushed toward the inner side of the connector 6 in the X-axis direction as shown in Fig. 24, the lever part 41o is rotated in such a way that the stopper part 41f of the connector 6 is away from the engaging part 3d of the connection substrate 7, and the engaging state of the engaged part 41b of the connector 6 with the engaging part 3d of the connection substrate 7 is released, as shown in Fig. 25.

After that, when the connector 6 and the connection substrate 7 are moved in the Y-axis direction in such a way that they are relatively away from each other, the state in which the connector 6 and the connection substrate 7 are connected to each other can be released. Then, by replacing, for example, the connector 6 or the connection substrate 7 by another one and performing the aforementioned flow of connecting the connector 6 to the connection substrate 7, the connector 6 or the connection substrate 7 can be easily replaced by another one.

In the connector 6, the connector unit 5, and the method for connecting to the connection substrate 7 in the connector 6 as well, the part on the positive side of the Y-axis including the third part 24c of each of the contacts 24 in the first contact group 21 and the part on the positive side of the Y-axis including the third part 25c of each of the contacts 25 in the second contact group 22 are not surrounded by the insulating member 41 as seen from the Z-axis direction. Therefore, it is possible to prevent or reduce a decrease in impedance, which can contribute to improving signal transmission characteristics.

In addition, the engaging state of the engaging part 3d of the connection substrate 7 with the engaged part 41b of the connector 6 can be easily released compared to that in the connector unit 1 according to the first embodiment. Therefore, the connector 6 or the connection substrate 7 can be easily replaced by another one compared to that in the connector unit 1 according to the first embodiment.

The configuration of the connector according to the above embodiments is merely an example. It is sufficient that the protruding part of the insulating member include an engaged part and a contacting part, and the end parts on the positive side of the Y-axis of the first contact group 21 and the second contact group 22 be disposed between the protruding parts of the insulating member in a state in which they are protruded on the positive side of the Y-axis from the insulating member as seen from the Z-axis direction.

Further, the configuration of the connection substrate according to the above embodiments is also merely an example, and it is sufficient that the connection substrate include engaging parts that can engage with the engaged parts of the connector.

From the disclosure thus described, it will be obvious that the embodiments of the disclosure may be varied in many ways. Such variations are not to be regarded as a departure from the spirit and scope of the disclosure, and all such modifications as would be obvious to one skilled in the art are intended for inclusion within the scope of the following claims.

## Claims

1. A connector (2, 6) that connects a connection substrate (3, 7) to a connection connector (33), the connector (2, 6) comprising:
a contact assembly (12) including a first contact group (21) and a second contact group (22) that can be connected to the connection substrate (3, 7) in a state in which the first contact group (21) and the second contact group (22) sandwich the connection substrate (3, 7) and
an insulating member (23, 41) that holds the first contact group (21) and the second contact group (22), wherein
the insulating member (23, 41) includes:
a main body (23a) configured to hold the first contact group (21) and the second contact group (22);
protruding parts (23b, 41a) that are protruded from the main body (23a) in a direction in which the connection connector (33) is inserted into the connector (2, 6) and are disposed in such a way that they are spaced apart from each other in a width direction of the connector (2, 6);
engaged parts (23f, 41b) that are disposed in the protruding parts (23b, 41a) and with which engaging parts (3d) disposed in side parts of the connection substrate (3, 7) are engaged; and
contacting parts (23i, 41g) that are disposed in the protruding parts (23b, 41a) and are in contact with side surfaces of the connection substrate (3, 7),
surfaces of the engaged parts (23f, 41b) that are opposed to each other in a thickness direction of the connector (2, 6) sandwich the side parts of the connection substrate (3, 7), and
end parts (24c, 25c) of each of the first contact group (21) and the second contact group (22) connected to the connection substrate (3, 7) are disposed between the protruding parts (23b, 41a) in a state in which the end parts are protruded from the insulating member (23, 41) in a direction in which the connection connector (33) is inserted into the connector (2, 6) as seen from the thickness direction of the connector (2, 6).

2. The connector (6) according to claim 1, wherein the insulating member (41) includes releasing parts (41c) that release the engaging state of the engaging parts (3d) of the connection substrate (7) with the engaged parts (41b).

3. The connector (6) according to claim 2, wherein
the engaged parts (41b) each include a stopper part (41f) that is disposed in the direction in which the connection connector is inserted into the connector (6) with respect to the engaging part (3d) of the connection substrate (7) in a state in which the engaging part (3d) of the connection substrate (7) is engaged with the engaged part (41b), and
the releasing parts (41c) each comprise:
an action point part to which a force is input in order to push the stopper part (41f) toward an outer side of the connector (6) in a width direction of the connector (6);
a supporting point part that is disposed between the stopper part (41f) of the engaged part (41b) and the action point part in the direction in which the connection connector is inserted into the connector (6), and is in contact with the connection substrate (7) in a state in which the force is input to the action point part; and
a lever part (41o) in which the stopper part (41f), the action point part, and the supporting point part are disposed.

4. The connector (2, 6) according to any one of claims 1 to 3, wherein
the engaged parts (23f, 41b) each include an inclined part (23k, 411, 41m) that is inclined on the outward of a width direction of the connector (2, 6) toward the direction in which the connection connector (33) is inserted into the connector (2, 6), and
when the engaging parts (3d) of the connection substrate (3, 7) are engaged with the engaged parts (23f, 41b), the engaging parts (3d) of the connection substrate (3, 7) are in contact with the inclined parts (23k, 411, 41m) and a force applied to the outer side of the width direction of the connector (2, 6) can be acted on the engaged parts (23f, 41b).

5. The connector (2, 6) according to claim 4, wherein the insulating member (23, 41) includes elastic deformation parts (23g, 41d) that are disposed in parts of the protruding parts (23b, 41a) in a direction in which the connection connector (33) is removed from the connector (2, 6) and elastically deform the protruding parts (23b, 41a) toward the outer side of the width direction of the connector (2, 6).

6. The connector (2, 6) according to any one of claims 1 to 3, wherein the first contact group (21) and the second contact group (22), and the connection substrate (3, 7) are connected to each other by solderless means.

7. A connector unit (1, 5) comprising:
the connector (2, 6) according to any one of claims 1 to 3; and
a connection substrate (3, 7) connected to the connector (2, 6),
wherein the connection substrate (3, 7) includes engaging parts (3d) that are disposed in side parts of the connection substrate (3, 7) and are engaged with engaged parts (23f, 41b) of the connector (2, 6).

8. The connector unit (1, 5) according to claim 7, wherein
the connector (2, 6) includes, in each of the engaged parts (23f, 41b), a first inclined part (23k, 41m) that is inclined on the outward of a width direction of the connector (2, 6) toward a direction in which the connection connector (33) is inserted into the connector (2, 6),
the connection substrate (3, 7) includes, in each of the engaging parts (3d), a second inclined part (3e) that is inclined on the inward of the width direction of the connection substrate (3, 7) toward a connection side of the connection substrate (3, 7) to the connector (2, 6), and
when the engaging parts (3d) of the connection substrate(3, 7) are engaged with the engaged parts (23f, 41b) of the connector (2, 6), the second inclined parts (3e) of the connection substrate (3, 7) are in contact with the first inclined parts (23k, 411, 41m) of the connector (2, 6) and a force applied to the outer side of the width direction of the connector (2, 6) can be acted on the engaged parts (23f, 41b) of the connector (2, 6).

9. The connector unit (1, 5) according to claim 7, wherein
the connection substrate (3, 7) includes cutouts (3c, 7c) on side parts of the connection substrate (3, 7), and
the engaging parts (3d) are disposed in the respective cutouts (3c, 7c).

10. The connector unit (1, 5) according to claim 7, wherein
the connection substrate (3, 7) includes a rigid flexible substrate part (3a, 7a) and a flexible substrate part (3b, 7b), and
the rigid flexible substrate part (3a, 7a) is connected to the connector (2, 6).

11. A method for connecting to a connection substrate (3, 7) in a connector (2, 6) that connects a connection substrate (3, 7) to a connection connector (33), the method comprising:
a process of sandwiching side parts of the connection substrate (3, 7) by engaged parts (23f, 41b) in a thickness direction of the connector (2, 6) while engaging engaging parts (3d) disposed in the side parts of the connection substrate (3, 7) with engaged parts (23f, 41b) disposed in protruding parts (23b, 41a) that are protruded from a main body (23a) of an insulating member (23, 41) for holding a first contact group (21) and a second contact group (22) in a direction in which the connection connector (33) is inserted into the connector (2, 6) and are disposed in such a way that they are spaced apart from each other in a width direction of the connector (2, 6);
a process of causing side surfaces of the connection substrate (3, 7) to be in contact with contacting parts (23i, 41g) disposed in the protruding parts (23b, 41a) of the insulating member (23, 41) of the connector (2, 6) to sandwich the connection substrate (3, 7) by the contacting parts (23i, 41g) in the width direction of the connector (2, 6); and
a process of connecting, to the connection substrate (3, 7), parts (24c, 25c) of the first contact group (21) and the second contact group (22) that are protruded from the insulating member (23, 41) in a direction in which the connection connector (33) is inserted into the connector (2, 6) between the protruding parts (23b, 41a) as seen from the thickness direction of the connector (2, 6).

12. The method for connecting to the connection substrate (3, 7) in the connector (2, 6) according to claim 11, wherein second inclined parts (3e) that are disposed in the engaging parts (3d) of the connection substrate (3, 7) and are inclined on the inward of the width direction of the connection substrate (3, 7) toward a connection side of the connection substrate (3, 7) to the connector (2, 6) are caused to contact first inclined parts (23k, 411, 41m) that are disposed in the engaged parts (23f, 41b) of the connector (2, 6) and are inclined on the outward of the width direction of the connector (2, 6) toward a direction in which the connection connector (33) is inserted into the connector (2, 6), and the engaged parts (23f, 41b) of the connector (2, 6) are pushed toward the outer side of the width direction of the connector (2, 6).
